**Europäisches Patentamt**

**European Patent Office**

**Office européen des brevets**

(19)

(11) Numéro de publication: **0 101 374 B1**

(12) **FASCICULE DE BREVET EUROPEEN**

(45) Date de publication du fascicule du brevet:
07.01.87

(51) Int. Cl.⁴: **H 01 S 3/02, H 01 S 3/045**

(21) Numéro de dépôt: **83401626.3**

(22) Date de dépôt: **08.08.83**

(54) **Embase pour laser à semi-conducteur et son procédé de fabrication.**

(30) Priorité: **12.08.82 FR 8214042**

(43) Date de publication de la demande:
**22.02.84 Bulletin 84/8**

(45) Mention de la délivrance du brevet:
**07.01.87 Bulletin 87/2**

(84) Etats contractants désignés:
**BE CH DE GB IT LI NL SE**

(56) Documents cités:
**GB - A - 2 050 896**

**JOURNAL OF APPLIED PHYSICS, vol. 46, no. 2, février 1975, American Institute of Physics, NEW YORK (US), W.B. JOYCE et al.: "Thermal resistance of heterostructure lasers", pages 855-862**

(73) Titulaire: **Demeure, Loïc, Route de Pleumeur, F-22700 Perros Guirec (FR)**
Titulaire: **Le Rouzic, Jean, Convenant An Dour Saint Quay Perros, F-22700 Perros Guirec (FR)**
Titulaire: **Simon, Jean Claude, 23, rue de Trestrignel, F-22700 Perros Guirec (FR)**

(72) Inventeur: **Demeure, Loïc, Route de Pleumeur, F-22700 Perros Guirec (FR)**
Inventeur: **Le Rouzic, Jean, Convenant An Dour Saint Quay Perros, F-22700 Perros Guirec (FR)**
Inventeur: **Simon, Jean Claude, 23, rue de Trestrignel, F-22700 Perros Guirec (FR)**

(74) Mandataire: **Mongrédien, André et al, c/o BREVATOME 25, rue de Ponthieu, F-75008 Paris (FR)**

## Description

La présente invention a pour objet une embase pour laser à semiconducteur et son procédé de fabrication.

Une embase pour laser à semiconducteur est une pièce destinée à servir de support mécanique à la structure semiconductrice siège de l'effet laser, à permettre une dissipation de la chaleur dégagée dans cette structure et à faciliter les connexions électriques avec une source d'alimentation.

Du document «Journal of Applied Physics, Vol. 46, No. 2, février 1975, pages 885–862, une embase pour laser à semiconducteur est connue, cette embase comprenant un support métallique monobloc présentant une partie prismatique formée par deux plans également inclinés par rapport à un plan de symétrie. La partie prismatique présentant un champ supérieur poli destiné à recevoir une puce laser dont la longueur est égale à l'épaisseur du champ supérieur poli.

Du document «GB-A 2 050 896 une embase pour laser à semiconducteur est connue, cette embase comprenant un support métallique monobloc, sur lequel est brasée une plaquette d'interconnexion de forme parallélépipédique, constituée par un substrat isolant recouvert d'une couche métallique susceptible d'être reliée par une connexion à la puce laser.

Etant donné l'extrême sensibilité de lasers à semiconducteur, le problème de la réalisation d'une embase adéquate a toujours été au premier plan des préoccupations des spécialistes de ce domaine. En général, l'embase utilisée est constituée par un support métallique monobloc dont la face supérieure est polie et reçoit la puce laser. Mais une telle structure présente deux inconvénients:

– la surface supérieure de l'embase se trouve être bombée après polissage, du fait de sa dimension importante, ce qui nuit à un bon contact thermique entre la puce et l'embase;

– les miroirs du laser, qui encadrent la structure semiconductrice, sont très difficilement accessibles, une fois l'ensemble monté.

La présente invention a justement pour but de remédier à ces inconvénients en proposant une embase pour laquelle la partie recevant la puce laser est étroite et ne présente pas de bombage et, qui, en outre, laisse accessibles les miroirs du laser.

Ce but est atteint, selon l'invention, par une embase comprenant un support métallique monobloc présentant une partie prismatique formée par deux plans également inclinés par rapport à un plan de symétrie, cette partie prismatique étant percée d'une fente pratiquée dans ce plan de symétrie, une lamelle métallique étant brasée dans la fente, cette lamelle présentant un champ supérieur poli destiné à recevoir une puce laser dont la longueur est égale à l'épaisseur de la lamelle, le support présentant en outre un socle plan sur lequel est brasé une plaquette d'interconnexion de forme parallélépipédique, cette plaquette étant constituée par un substrat isolant recouvert d'une couche métallique susceptible d'être reliée par une connexion à la puce laser.

De préférence, le support et la lamelle sont en cuivre.

De préférence encore, la plaquette d'interconnexion est constituée par un substrat en alumine frittée recouvert sur une face par une couche conductrice sérigraphiée à l'or, et sur l'autre face, (destinée à être en contact avec le socle) par une couche conductrice de la chaleur réalisée à l'aide d'une pâte argent-palladium.

La présente invention a également pour objet un procédé de fabrication de l'embase qui vient d'être définie. Ce procédé est caractérisé en ce qu'il comprend les opérations suivantes:

– usinage d'un support métallique par fraisage et rectification pour former la partie prismatique et le socle,

– sciage d'une fente dans la partie prismatique et dans le socle,

– fabrication d'une lamelle par laminage d'une bande métallique, découpage à la longueur désirée, rectification sur trois champs et polissage du quatrième, devant recevoir la puce laser,

– fabrication d'une plaquette d'interconnexion par sérigraphie d'une pâte métallique sur un substrat isolant,

– introduction de la lamelle dans la fente, et mise en place de la plaquette d'interconnexion sur le socle,

– brasage de la lamelle et de la plaquette.

Les caractéristiques de l'invention apparaîtront mieux après la description qui suit, d'exemples de réalisation donnés à titre explicatif et nullement limitatif. Cette description se réfère à des dessins sur lesquels:

– la fig. 1 représente une vue générale d'une embase conforme à l'invention,

– la fig. 2 représente le support monobloc,

– la fig. 3 représente le support après sciage,

– la fig. 4 représente une lamelle,

– la fig. 5 représente une plaquette d'interconnexion.

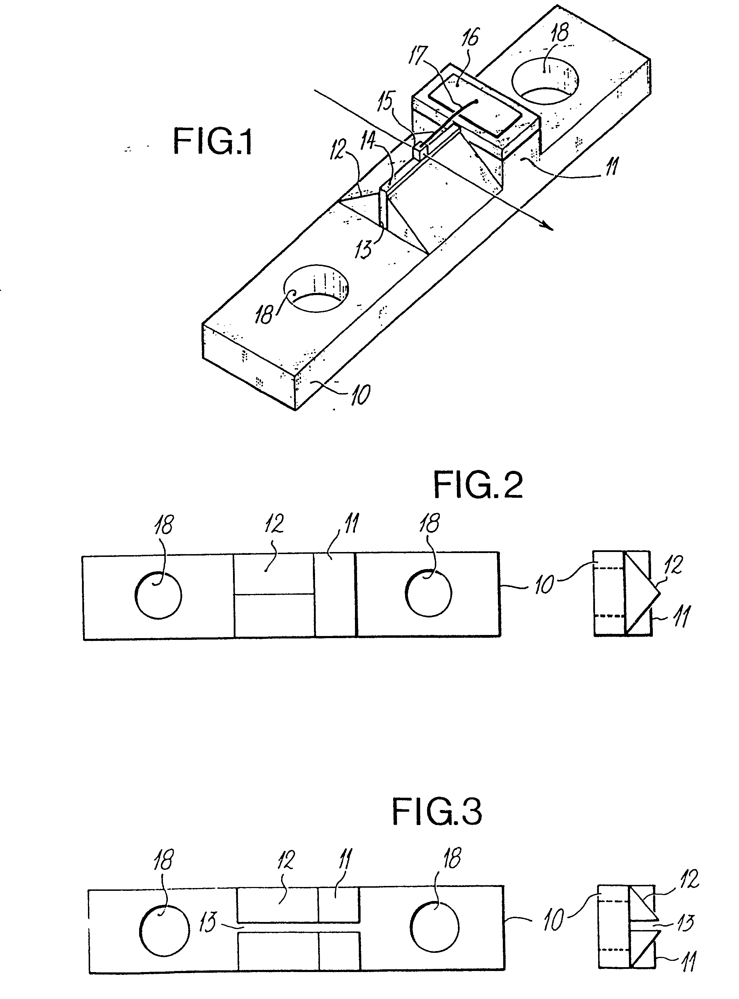

L'embase représentée sur la figure 1 comprend un support métallique monobloc 10 présentant une partie prismatique 12 formée par deux plans également inclinés par rapport au plan de symétrie de l'ensemble. Cette partie prismatique est percée d'une fente 13 pratiquée dans le plan de symétrie. Une lamelle métallique 14 est brasée dans la fente, cette lamelle présentant un champ supérieur poli destiné à recevoir une puce laser 15. La longueur de cette puce est égale à l'épaisseur de la lamelle. Le rayonnement laser est donc dirigé transversalement. L'embase comprend encore un socle 11 sur lequel est brasée une plaquette d'interconnexion 16 de forme parallélépipédique. Le support peut comprendre des trous de fixation 18.

On conçoit que la forme prismatique 12 dégage la puce laser et les miroirs sans pour autant nuire au contact thermique qui reste établi sur la totalité de la base de la puce laser.

Le procédé de fabrication d'une telle embase peut comporter les opérations suivantes, dans ce qui n'est qu'un exemple de mise en oeuvre.

Le support est obtenu par fraisage et rectification d'un rond ou d'un étiré de cuivre, par exemple de type Cu recuit. On obtient la pièce représentée sur la figure 2, avec son socle 11 et sa partie prismatique 12.

La fente 13 est obtenue par sciage sur fraiseuse à l'aide d'une fraise-scie de largeur telle qu'on obtienne en une seule passe la largeur souhaitée. Celle-ci est égale, à l'épaisseur de la lamelle à monter, augmentée de 30 à 40 μm.

Un ébavurage est ensuite effectué, suivi d'un dégraissage aux solvants chlorés ou fluorés dans un bac à ultrasons.

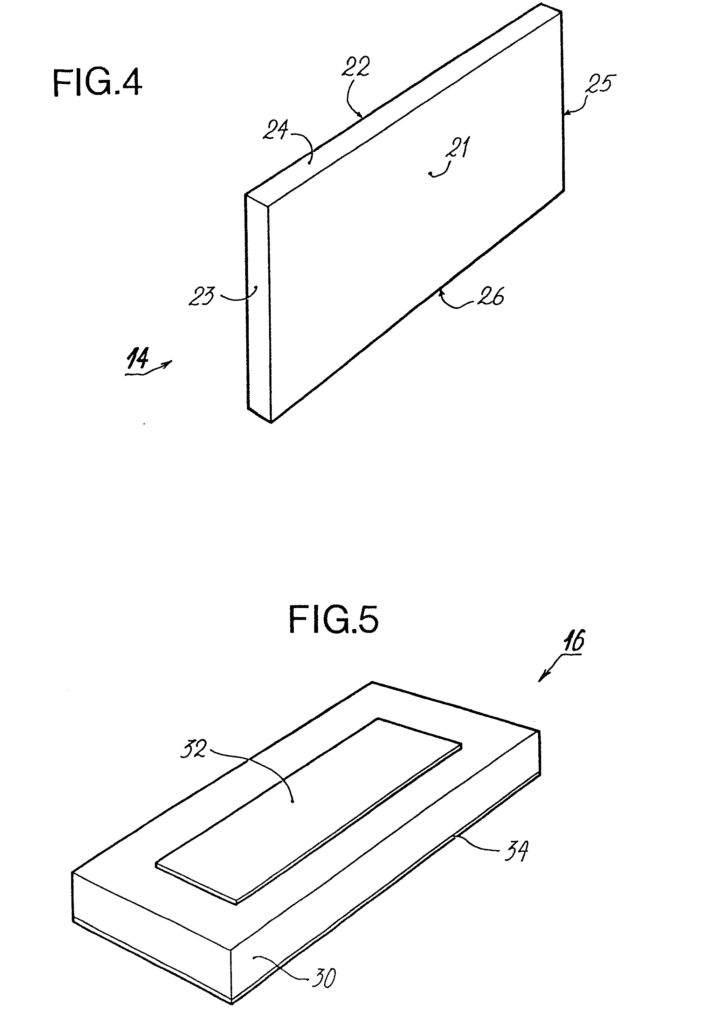

La pièce obtenue est représentée sur la fig. 3.

La lamelle est ensuite réalisée de préférence en cuivre recuit, comme pour le support. La matière est approvisionnée en feuilles d'où sont tirées des bandes de largeur 2,5 mm et d'environ 250 mm de longueur. Chaque bande est passée dans un laminoir pour amener son épaisseur à celle de la lamelle à ± 1 μm. Les bandes sortant de laminage sont découpées à une longueur de 4,5 mm à l'aide d'une fraise-scie. Après découpe, les lamelles sont nettoyées à l'aide d'un solvant chloré ou fluoré. Chaque lamelle subit alors une rectification sur trois faces, référencées 23, 25, 26 sur la figure 4, les faces 21 et 22 restant brutes de laminage. Les lamelles font ensuite l'objet d'un polissage sur leur face 24 destinée à recevoir la puce laser. Pour cette opération de polissage, un bloc de lamelles est maintenu dans un montage spécial possédant deux flasques venant en appui sur les faces latérales, respectivement 21 et 22, des deux lamelles d'extrémité du bloc. Après polissage du bloc, les lamelles sont séparées les unes des autres. Cette manière de procéder permet d'obtenir une face 24 poli-miroir sans faire tomber les bords. Seuls les bords du montage enserrant les lamelles présentent un bord abattu.

La plaquette d'interconnexion est représentée sur la figure 5. Elle est constituée d'un substrat 30 en alumine frittée recouvert d'une couche conductrice 32 servant à l'interconnexion et réalisée par sérigraphie d'une pâte à l'or sans verre. La face inférieure servant à la fixation sur le socle du support est recouverte d'une couche 34 obtenue à l'aide d'une pâte argent-palladium. Plusieurs plaquettes peuvent être sérigraphiées simultanément et cuites sur un substrat d'alumine, lequel est ensuite découpé à l'aide d'un équipement d'usinage par faisceau laser.

La lamelle est fixée par brasage tendre dans la fente pratiquée dans le support. L'alliage d'apport est choisi en fonction de sa température de fusion et des caractéristiques de tenue thermique demandée à l'embase. Par exemple pour une tenue à 160°C, on peut utiliser un alliage étain 62,5%, plomb 36%, argent 1,5% dont la température de fusion est 179°C. Pour une tenue à 200°C, on peut utiliser un alliage étain 95% antimoine 5% dont la température de fusion est 240°C.

L'opération de montage de la lamelle comprend deux phases: revêtement des faces de la fente par le métal d'apport, puis brasage de la lamelle.

Le revêtement des faces de la fente est effectué en utilisant une préforme de l'alliage d'apport choisi, ce qui permet de ne traiter que la fente.

La mise en oeuvre de cette méthode se fait de la manière suivante: après dégraissage aux solvants chlorés ou fluorés, on décape le support de la figure 3 dans une solution à 5% d'acide chlorhydrique. On prépare une préforme en alliage d'apport dont les dimensions sont:

longueur = longueur de la fente
épaisseur = largeur de la fente
largeur = entre 400 est 600 μm.

On engage la préforme en la centrant dans la fente de manière qu'elle affleure à la partie supérieure. On porte le support à une température légèrement supérieure à la température de fusion de la préforme, par exemple en le posant sur une plaque chauffante. La préforme fond en s'écoulant sur les côtés et le fond de la fente. Pendant que l'alliage est en fusion, on passe dans la fente un feuillard d'acier inoxydable dont l'épaisseur est égale à celle de la fente moins 100 μm. Un mouvement longitudinal de va et vient est appliqué au feuillard, ce qui permet d'obtenir un dépôt sans surépaisseur. On revêt du même alliage la partie plane du support devant recevoir la plaquette d'interconnexion. On refroidit l'ensemble en plaçant le support sur un bon dissipateur thermique.

A partir d'un support ainsi préparé, on introduit dans la fente une préforme d'alliage de même nature que celle qui a été utilisée précédemment, mais dont les dimensions sont:

longueur: 2 mm
largeur: 0,6 mm
épaisseur: celle de la largeur de la fente moins 100 μm.

On engage la lamelle dans la fente en la centrant. On place en position sur son support la plaquette d'interconnexion. On porte le support de montage à la température de fusion de la préforme et on effectue sur les extrémités de la lamelle une pression permettant d'amener celle-ci en butée au fond de la fente.

Au cours de cette opération, la lamelle et la plaquette d'interconnexion se trouvent brasées simultanément. On refroidit la pièce, puis on nettoie celle-ci dans un solvant chloré. Les embases sont alors stockées en enceinte déshydratée.

L'ensemble monté peut faire l'objet d'un traitement de surface par dépôts électrolytiques comprenant un dépôt de nickel brillant de 0,5 à 1 μm d'épaisseur, revêtu lui-même d'un dépôt d'or de 0,4 à 0,6 μm d'épaisseur.

**Revendications**

1. Embase pour laser à semiconducteur comprenant un support métallique monobloc (10) présentant une partie prismatique (12) formée par deux plans également inclinés par rapport à un plan de symétrie, cette partie prismatique étant percée d'une fente (13) pratiquée dans ce plan de symétrie, l'embase comprenant encore une lamelle métallique (14) brasée dans la fente (13), cette lamelle présentant un champ supérieur pol destiné à recevoir une puce laser (15) dont la longueur est égale à l'épaisseur de la lamelle, le support présentant en outre un socle plan (11) sur lequel est brasée une plaquette d'interconnexion (16) de forme parallélépipédique, constituée par un substrat isolant (30) recouvert d'une couche métallique (32) susceptible d'être reliée par une connexion (17) à la puce laser.

2. Embase selon la revendication 1, caractérisée en ce que le support et la lamelle sont en cuivre.

3. Embase selon la revendication 1, caractérisée en ce que la plaquette d'interconnexion (16) est constituée par un substrat en alumine frittée (30) recouvert sur une face par une couche conductrice (32) sérigraphiée à l'or.

4. Embase selon la revendication 3, caractérisée en ce que la plaquette d'interconnexion (16) est recouverte sur la face destinée à être en contact avec le socle d'une couche conductrice de la chaleur (34) réalisée à l'aide d'une pâte argent-palladium.

5. Embase selon l'une quelconque des revendications 1 à 4, caractérisée en ce qu'elle est recouverte d'un dépôt électrolytique de nickel revêtu d'un dépôt d'or.

6. Procédé de fabrication d'une embase conforme à la revendication 1, caractérisé en ce qu'il comprend les étapes suivantes:
   – usinage d'un support métallique (10) par fraisage et rectification pour former le socle plan (11) et la partie prismatique (12),
   – sciage d'une fente (13) dans la partie prismatique (12) et dans le socle (11)
   – fabrication d'une lamelle (14) par laminage d'une bande métallique, découpage à la longueur désirée, rectification sur trois champs (23, 25, 26) et polissage du quatrième (24) devant recevoir la puce laser,
   – fabrication d'une plaquette d'interconnexion (16) par sérigraphie d'une pâte métallique sur un substrat isolant (30),
   – introduction de la lamelle (14) dans la fente et mise en place de la plaquette d'interconnexion (16) sur le socle,
   – brasage de la lamelle (14) et de la plaquette (16).

7. Procédé selon la revendication 6, caractérisé en ce que l'opération de polissage porte sur un bloc de lamelles toutes polies en même temps.

8. Procédé selon la revendication 6, caractérisé en ce que l'opération de brasage comprend les opérations suivantes:
   – on introduit dans la fente (13) une première préforme en un alliage d'apport présentant une longueur égale à la largeur de la fente, cette préforme affleurant la partie supérieure de la fente,
   – on porte l'ensemble à une température légèrement supérieure à la température de fusion de la préforme,
   – pendant que l'alliage est en fusion, on passe dans la fente un feuillard qu'on anime d'un mouvement de va-et-vient,
   – on revêt du même alliage la partie plane (11) du support destinée à recevoir la plaquette d'interconnexion,
   – on introduit dans la fente une seconde préforme dudit alliage de longueur plus faible que la longueur de la fente,
   – on engage la lamelle dans la fente,
   – on place sur le socle la plaquette d'interconnexion,
   – on porte l'ensemble à la température de fusion de la préforme et on effectue sur les extrémités de la lamelle une pression permettant d'amener celle-ci en butée avec le fond de la fente.

**Patentansprüche**

1. Bodenplatte für einen Halbleiterlaser mit einem Metallträger (10) aus einem Stück, der einen prismatischen Abschnitt (12), aufweist, der von zwei in gleicher Weise im Bezug auf eine Symmetrieebene geneigten Ebenen gebildet und von einem Schlitz (13) durchbrochen ist, der in dieser Symmetrieebene hergestellt ist, mit ferner einem in den Schlitz (13) eingelöteten Metallplättchen, welches einen oberen polierten Bereich zur Aufnahme eines Laserchips (15) aufweist, dessen Länge gleich der Dicke des Plättchens ist, wobei der Träger ferner einen ebenen Sockel (11) aufweist, auf den eine Verbindungsplatte (16) in der Form eines Parallelepipeds gelötet ist, die von einem isolierenden Substrat (30) gebildet ist, das mit einer Metallschicht (32) überzogen ist, welche über eine Verbindung (17) mit dem Laserchip verbindbar ist.

2. Bodenplatte nach Anspruch 1, dadurch gekennzeichnet, dass der Träger und das Plättchen aus Kupfer bestehen.

3. Bodenplatte nach Anspruch 1, dadurch gekennzeichnet, dass die Verbindungsplatte (16) von einem Substrat (30) aus gesintertem Aluminiumoxid gebildet ist, das auf einer Seite mit einer durch Siebdruck aufgebrachten leitenden Goldschicht (32) bedeckt ist.

4. Bodenplatte nach Anspruch 3, dadurch gekennzeichnet, dass die Verbindungsplatte (16) auf der zur Berührung mit dem Sockel bestimmten Seite mit einer wärmeleitfähigen Schicht (34) bedeckt ist, welche mit Hilfe einer Silber-Palladium-Paste hergestellt ist.

5. Bodenplatte nach einem der Ansprüche 1–4, dadurch gekennzeichnet, dass sie mit einem galvanischen Niederschlag aus Nickel bedeckt ist, der mit einem Goldniederschlag überzogen ist.

6. Verfahren zur Herstellung einer Bodenplatte nach Anspruch 1, dadurch gekennzeichnet, dass es folgende Schritte umfasst:
   – Bearbeiten eines Metallträgers (10) durch Fräsen und Schleifen, um den ebenen Sockel (11) und den prismatischen Abschnitt (12) zu bilden,
- Einsägen eines Schlitzes (13) in den prismatischen Abschnitt (12) und in den Sockel (11),
- Herstellen eines Plättchens (14) durch Walzen eines Metallbandes, Zuschneiden auf die erwünschte Länge, Abschleifen auf drei Bereichen (23, 25, 26) und Polieren des vierten (24) vor der Aufnahme des Laserchips,
- Herstellen einer Verbindungsplatte (16) durch Siebdruck einer Metallpaste auf ein isolierendes Substrat (30),
- Einbringen des Plättchens (14) in den Schlitz und Anordnen der Verbindungsplatte (16) auf dem Sockel,
- Verlöten des Plättchens (14) und der Platte (16).

7. Verfahren nach Anspruch 6, dadurch gekennzeichnet, dass der Poliervorgang an einem Block von Plättchen vorgenommen wird, die alle gleichzeitig poliert werden.

8. Verfahren nach Anspruch 6, dadurch gekennzeichnet, dass der Lötvorgang die folgenden Schritte umfasst:
- man führt in den Schlitz (13) eine erste Vorform einer Aufschweisslegierung ein, die eine Länge gleich der Schlitzbreite aufweist, wobei diese Vorform bündig mit dem oberen Abschnitt des Schlitzes ist,
- man erwärmt die Gesamtheit auf eine Temperatur etwas oberhalb der Schmelztemperatur der Vorform,
- während die Legierung geschmolzen ist, bringt man ein Bandmaterial in den Schlitz ein, welches man hin und her bewegt,
- man überzieht mit der gleichen Legierung den ebenen Teil (11) des Trägers, der die Verbindungsplatte aufnehmen soll,
- man bringt in den Schlitz eine zweite Vorform aus der Legierung ein, die eine geringere Länge als die Länge des Schlitzes aufweist,
- man bringt das Plättchen in den Schlitz ein,
- man ordnet auf dem Sockel die Verbindungsplatte an,
- man erwärmt die Gesamtheit auf die Schmelztemperatur der Vorform und übt auf die Enden des Plättchens einen Druck aus, der ermöglicht, dieses bis zum Anstossen auf den Boden des Schlitzes zu bringen.

**Claims**

1. Base for a semiconductor laser, comprising a onepiece metal support (10) having a prismatic part (12) formed by two planes inclined equally relative to a plane of symmetry, this prismatic part being perforated with a slot (13) made in this plane of symmetry, the base also possessing a metal strip (14) soldered in the slot (13), this strip having a polished upper zone intended for receiving a laser chip (15), the length of which is equal to the thickness of the strip, the support furthermore having a plane pedestal (11), on which is soldered a parallelepipedic interconnection board (16) consisting of an insulating substrate (30) covered with a metal layer (32) capable of being connected to the laser chip by means of a connection (17).

2. Base according to Claim 1, characterized in that the support and the strip are made of copper.

3. Base according to Claim 1, characterized in that the interconnection board (16) consists of a substrate made of sintered alumina (30) covered on one face with a conductive layer (32) screenprinted with gold.

4. Base according to Claim 3, characterized in that the interconnection board (16) is covered, on the face intended to be in contact with the pedestal, with a heat-conducting layer (34) produced by means of a silver/palladium paste.

5. Base according to any one of Claims 1 to 4, characterized in that it is covered with an electroplated nickel deposit coated with a gold deposit.

6. Process for producing a base according to Claim 1, characterized in that it comprises the following steps:
- machining a metal support (10) by means of milling and grinding, to form the plane pedestal (11) and the prismatic part (12),
- sawing a slot (13) in the prismatic part (12) and in the pedestal (11),
- producing a strip (14) by rolling a metal band, cutting the latter to the desired length, grinding three zones (23, 25, 26) and polishing the fourth zone (24) intended for receiving the laser chip,
- producing an interconnection board (16) by the screenprinting of a metallic paste on an insulation substrate (30),
- inserting the strip (14) into the slot and fitting the interconnection board (16) on the pedestal, and
- soldering the strip (14) on the board (16).

7. Process according to Claim 6, characterized in that the polishing operation is carried out on a block of strips which are all polished at the same time.

8. Process according to Claim 6, characterized in that the soldering operation comprises the following steps:
- a first preform made of hard-facing alloy and having a length equal to the width of the slot (13) is introduced into the latter, this preform being flush with the upper part of the slot,
- the assembly as a whole is brought to a temperature slightly higher than the melting point of the preform, while the alloy is in the molten state, a ribbon driven in a to-and-fro movement is inserted into the slot,
- the plane part (11) of the support intended for receiving the interconnection board is covered with the same alloy,
- a second preform of the said alloy, of a shorter length than that of the slot, is introduced into the slot,
- the strip is engaged in the slot, the interconnection board is placed on the pedestal, the assembly as a whole is brought to the melting point of the preform, and pressure is exerted on the ends of the strip, making it possible to bring the latter up against the bottom of the slot.

FIG.1

FIG.2

FIG.3

FIG.4

22

24

21

25

23

26

14

FIG.5

16

32

34

30